# EUROPÄISCHE PATENTSCHRIFT

(11) **EP 2 389 597 B1**
(45) Veröffentlichungstag und Bekanntmachung des Hinweises auf die Patenterteilung: **08.04.2015**
(21) Anmeldenummer: 10704113.9
(22) Anmeldetag: 14.01.2010
(51) Int. Cl.: G01R 31/36, G01R 19/165, H02J 7/00

(54) **SPANNUNGSERFASSUNG VON BATTERIEZELLEN**
DETECTING THE VOLTAGE IN BATTERY CELLS
DÉTECTION DE LA TENSION D'ÉLÉMENTS DE BATTERIE

(30) Priorität: 23.01.2009 DE 102009000396
(43) Veröffentlichungstag der Anmeldung: 30.11.2011
(73) Patentinhaber: Robert Bosch GmbH, 70442 Stuttgart (DE)
(72) Erfinder: BUTZMANN, Stefan, 71717 Beilstein (DE)
(86) Internationale Anmeldenummer: PCT/EP2010/050382
(87) Internationale Veröffentlichungsnummer: WO 2010/084073

(56) Entgegenhaltungen:
- EP-A1- 1 806 592
- EP-A2- 1 933 443
- WO-A1-00/43798
- WO-A1-2008/108979
- US-A- 5 818 201
- US-A1- 2007 114 973
- US-A1- 2007 285 054
- US-B1- 6 417 646

## Beschreibung

### Stand der Technik

Die vorliegende Erfindung betrifft ein Verfahren und eine Auswerteschaltung zur Erfassung der Spannung von vorzugsweise in Reihe geschalteten Batteriezellen eines Batteriesystems gemäß den Oberbegriffen der Patentansprüche 1 und 6. Solche Verfahren und Auswerteschaltungen sind aus der US 2007/114973 A1, der WO 2008/108979 A1 und der EP 1 933 443 A2 bekannt.

Es zeichnet sich ab, dass in Zukunft sowohl bei stationären Anwendungen. z.B. bei Windkraftanlagen, als auch in Fahrzeugen, z.B. in Hybridund Elektrofahrzeugen, vermehrt neue Batteriesysteme zum Einsatz kommen werden, an die sehr hohe Anforderungen bezüglich der Zuverlässigkeit gestellt werden. Hintergrund für diese hohen Anforderungen ist, dass ein Ausfall der Batterie zu einem Ausfall des Gesamtsystems führen kann, z.B. führt bei einem Elektrofahrzeug ein Ausfall der Traktionsbatterie zu einem sogenannten "Liegenbleiber". Ein weiterer Grund für diese hohen Anforderungen ist, dass ein Ausfall der Batterie auch zu einem sicherheitsrelevanten Problem führen kann, z.B. werden bei Windkraftanlagen Batterien eingesetzt, um bei starkem Wind die Anlage durch eine Rotorblattverstellung vor unzulässigen Betriebszuständen zu schützen.

Um die geforderten Leistungs- und Energiedaten mit dem Batteriesystem zu erzielen, werden üblicherweise einzelne Batteriezellen in Serie und teilweise zusätzlich auch parallel geschaltet.

Ein Problem beim Einsatz vieler einzelner in Reihe geschalteter Batteriezellen stellt die nicht perfekte Gleichheit der einzelnen Zellen dar, die insbesondere über die Lebensdauer ohne entsprechende Abhilfe zu ungleichen Zellspannungen führt. Da insbesondere bei Lithium-lonen-Batterien das

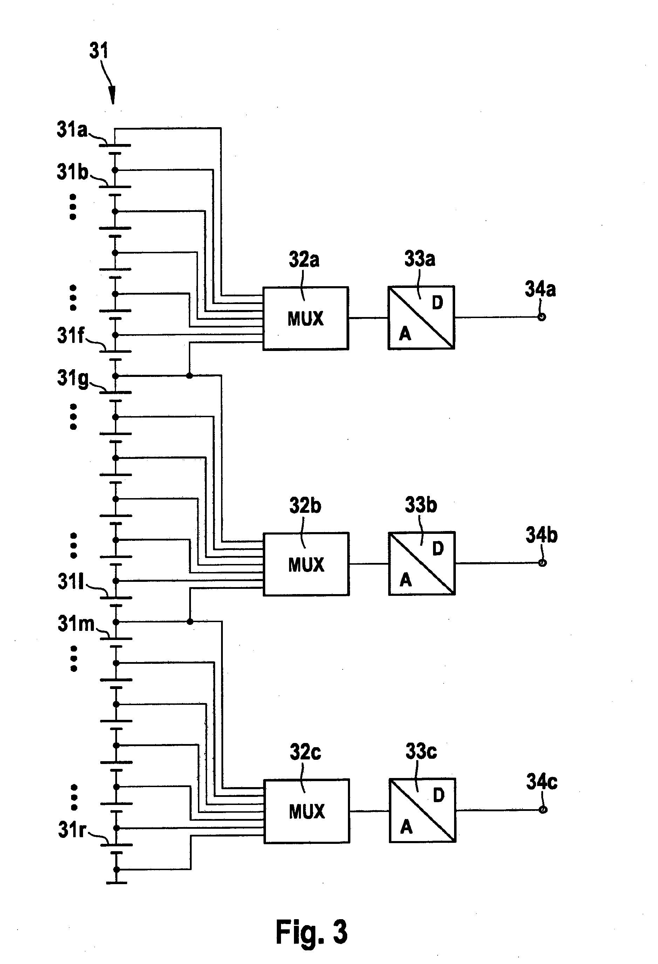

Überladen oder das Tiefentladen einzelner Zellen zu einer irreversiblen Schädigung der Batterie führt, müssen die Spannungen der Batteriezellen kontinuierlich überwacht werden, um gegebenenfalls Gegenmaßnahmen wie beispielsweise ein Zell-Balancing einleiten zu können. Zur Überwachung der Zellspannungen werden in der Regel Schaltungen verwendet, die entweder diskret aufgebaut oder integriert eingesetzt werden. Eine solche Schaltung ist beispielhaft in Figur 3 dargestellt. Hierbei werden mehrere solcher, jeweils über eine Batteriezelle 31a, 31b ... 31f abfallende Batteriezellspannungen über einen Multiplexer 32a nacheinander einem Analog-Digital-Konverter 33a zugeführt, der den jeweiligen Analogwert in einen Digitalwert übersetzt. Die so ermittelten Zellspannungen werden über einen Anschluss 34a einem Datenbus zugeführt, der diese an einen Mikrocontroller zur Weiterverarbeitung überträgt. Parallel dazu werden jeweils über eine Batteriezelle 31g ... 311 abfallende Batteriezellspannungen über einen Multiplexer 32b nacheinander einem Analog-Digital-Konverter 33b zugeführt, der den jeweiligen Analogwert in einen Digitalwert übersetzt. Die so ermittelten Zellspannungen werden über einen Anschluss 34b einem Datenbus zugeführt, der diese an den Mikrocontroller zur Weiterverarbeitung überträgt. Parallel dazu werden jeweils über eine Batteriezelle 31m ... 31r abfallende Batteriezellspannungen über einen Multiplexer 32c nacheinander einem Analog-Digital-Konverter 33c zugeführt, der den jeweiligen Analogwert in einen Digitalwert übersetzt. Die so ermittelten Zellspannungen werden über einen Anschluss 34c einem Datenbus zugeführt, der diese an den Mikrocontroller zur Weiterverarbeitung überträgt. Abhängig von der Anzahl der Batteriezellen und der Geschwindigkeit der verwendeten Baugruppen des Multiplexers und des Analog-Digital-Konverters können, wie in Figur 3 gezeigt, die einzelnen Batteriezellen 31a ... 31r des Batteriesystems 31 in Gruppen unterteilt werden, denen jeweils ein Multiplexer und ein Analog-Digital-Konverter zugeordnet ist. Alternativ können jedoch auch alle Batteriezellen 31a ... 31 r des Batteriesystems 31 lediglich durch einen Multiplexer und einen Analog-Digital-Konverter verarbeitet werden.

Nachteile dieses Verfahrens sind der zeitliche Versatz zwischen den Messungen, der mit zunehmender Zellenzahl pro Multiplexer zunimmt, die damit relativ geringe mögliche maximale Abtastrate des Verfahrens sowie der relativ hohe Preis geeigneter integrierter Schaltungen.

### Offenbarung der Erfindung

Das erfindungsgemäße Verfahren mit den Merkmalen des Patentanspruchs 1 und die erfindungsgemäße Auswerteschaltung mit den Merkmalen des Patentanspruchs 6 weisen demgegenüber den Vorteil auf, dass die gewünschte Zellspannungserfassung mit nur geringem Aufwand geschieht und eine nahezu zeitgleiche Abtastung aller Zellen ermöglicht wird. Demzufolge ist das erfindungsgemäße Verfahren zur Erfassung der Spannung von vorzugsweise in Reihe geschalteten Batteriezellen eines Batteriesystems durch die folgenden Schritte gekennzeichnet:
Anlegen eines abschnittsweise kontinuierlich verlaufenden Stroms an eine Reihenschaltung von Widerständen, deren Anzahl zu der Anzahl der Batteriezellen korrespondiert, deren Spannung erfasst wird, wobei jeder dieser Batteriezellen einer der Widerstände zugeordnet ist, Vergleichen der an einem jeweiligen einer Batteriezelle zugeordneten Widerstand abfallenden Spannung mit der Spannung der Batteriezelle, der der jeweilige Widerstand zugeordnet ist, und Ableiten der Spannung der jeweiligen Batteriezelle anhand eines Zeitpunkts, an dem eine über den dieser zugeordneten Widerstand abfallende Spannung der Spannung der jeweiligen Batteriezelle entspricht, diese übersteigt oder unter diese sinkt, und des Verlaufs des abschnittsweise kontinuierlich verlaufenden Stroms. Die erfindungsgemäße Auswerteschaltung zur Erfassung der Spannung von vorzugsweise in Reihe geschalteten Batteriezellen eines Batteriesystems ist entsprechend gekennzeichnet durch: eine Reihenschaltung von Widerständen, deren Anzahl zu der Anzahl der Batteriezellen korrespondiert, deren Spannung erfasst werden soll, wobei jeder dieser Batteriezellen einer der Widerstände zugeordnet ist, eine Stromquelle zur Erzeugung eines abschnittsweise kontinuierlich verlaufenden Stroms, der an die Reihenschaltung von Widerständen angelegt wird, eine Anzahl von Komparatoren, die der Anzahl von Widerständen entspricht, zum Vergleichen einer an einem jeweiligen einer Batteriezelle zugeordneten Widerstand abfallenden Spannung mit der Spannung der Batteriezelle, der der jeweilige Widerstand zugeordnet ist, und zum Ausgeben eines jeweiligen Ausgangssignals, wenn die an einem jeweiligen einer Batteriezelle zugeordneten Widerstand abfallende Spannung der Spannung der Batteriezelle entspricht, diese übersteigt oder unter diese sinkt, eine Auswerteschaltung zum Ableiten der Spannung der jeweiligen Batteriezelle anhand eines Zeitpunkts, an dem das jeweilige Ausgangssignal ausgegeben wird und des Verlaufs des abschnittsweise kontinuierlich verlaufenden Stroms.

Die Unteransprüche zeigen bevorzugte Weiterbildungen der Erfindung.

Besonders bevorzugt ist das erfindungsgemäße Verfahren derart ausgestaltet, dass der abschnittsweise kontinuierlich verlaufende Strom sägezahnförmig oder dreiecksförmig verläuft und/oder kontinuierlich steigt oder fällt. Korrespondierend ist die Stromquelle der erfindungsgemäßen Auswerteschaltung besonders bevorzugt so angepasst, dass sie einen abschnittsweise kontinuierlich verlaufenden Strom erzeugt, der sägezahnförmig oder dreiecksförmig verläuft und/oder kontinuierlich steigt oder fällt. Hierdurch ist die Verwendung von standardisierten Bauelementen und eine besonders einfache Zuordnung des Zeitpunkts, zu dem die über einen einer Batteriezelle zugeordneten Widerstand abfallende Spannung der Spannung der jeweiligen Batteriezelle entspricht, diese übersteigt oder unter diese sinkt, zu einer bestimmten Batteriezellenspannung besonders einfach möglich.

Das erfindungsgemäße Verfahren umfasst weiter zusätzlich oder alternativ bevorzugt, dass ein Bezugspotential eines einer Batteriezelle zugeordneten Widerstands auf ein Bezugspotential der Batteriezelle gebracht wird. Korrespondierend ist die erfindungsgemäßen Auswerteschaltung weiter zusätzlich oder alternativ bevorzugt gekennzeichnet durch eine Potentialverschiebeschaltung, die ein Bezugspotential eines einer Batteriezelle zugeordneten Widerstands auf ein Bezugspotential der Batteriezelle bringt. Durch diese Maßnahme ist ein besonders einfacher Vergleich der über einen einer Batteriezelle zugeordneten Widerstand abfallenden Spannung mit der Spannung der korrespondierenden Batteriezelle möglich.

Weiter alternativ oder zusätzlich wird bei dem erfindungsgemäßen Verfahren bevorzugt die Spannung einer ersten Hälfte der Batteriezellen des Batteriesystems mit Hilfe einer ersten Reihenschaltung von Widerständen und eines an diese angelegten ersten abschnittsweise kontinuierlich verlaufenden Strom erfasst, der aus mehr als der Hälfte der Batteriezellen des Batteriesystems gewonnen wird, und die Spannung einer zweiten Hälfte der Batteriezellen des Batteriesystems mit Hilfe einer zweiten Reihenschaltung von Widerständen und eines an diese angelegten ersten abschnittsweise kontinuierlich verlaufenden Stroms erfasst, der aus mehr als der Hälfte der Batteriezellen des Batteriesystems gewonnen wird. Dazu korrespondierend ist die erfindungsgemäße Auswerteschaltung zusätzlich oder alternativ bevorzugt gekennzeichnet durch eine erste Reihenschaltung von Widerständen und eine erste Stromquelle, die einen ersten abschnittsweise kontinuierlich verlaufenden Stroms an die erste Reihenschaltung von Widerständen anlegt, der aus mehr als der Hälfte der Batteriezellen des Batteriesystems gewonnen wird, um die Spannung einer ersten Hälfte der Batteriezellen des Batteriesystems zu erfassen, und eine zweite Reihenschaltung von Widerständen und eine zweite Stromquelle, die einen zweiten abschnittsweise kontinuierlich verlaufenden Strom an die zweite Reihenschaltung von Widerständen anlegt, der aus mehr als der Hälfte der Batteriezellen des Batteriesystems gewonnen wird, um die Spannung einer zweiten Hälfte der Batteriezellen des Batteriesystems zu erfassen. Durch diese Ausgestaltung können alle Batteriezelle des Batteriesystems erfasst werden, auch wenn es aufgrund des gewählten Schaltungskonzepts notwendig ist, dass der Spannungsabfall über den Widerständen größer sein kann, als die Spannung der gemessenen Batteriezellen.

Schließlich das erfindungsgemäße Verfahren in dieser Ausführungsform weiter bevorzugt dadurch gekennzeichnet, dass der zweite Strom erzeugt wird, indem der erste Strom gespiegelt wird. Korrespondierend ist die erfindungsgemäße Auswerteschaltung in dieser bevorzugten Ausführungsform weiter bevorzugt dadurch gekennzeichnet, dass eine Stromspiegelschaltung zur Erzeugung des zweiten Stroms durch Spiegeln des ersten Stroms vorgesehen ist.

Erfindungsgemäß umfasst der Ausdruck "Batterie" neben normalen Batterien auch, und insbesondere Akkumulatoren, durch "Batteriesystem" wird also insbesondere ein "Akkumulatorsystem" beschrieben und durch "Batteriezelle" vorzugsweise eine "Akkumulatorzelle", wobei hier jede beliebige Art von Stromspeichern umfasst ist, die wieder aufgeladen werden kann. Vorzugsweise ist das erfindungsgemäße Batteriesystem ein Lithium-lonen-Akkumulatorsystem mit Lithium-Ionen-Akkumulatorzellen.

Erfindungsgemäß erfolgt besonders bevorzugt die Zellspannungserfassung mittels eines zeitlichen Verfahrens. Kern dieses bevorzugten Verfahrens ist die Erzeugung eines sägezahnförmigen Stroms, der parallel zu allen zu messenden Batteriezellen geführt wird und an Widerständen einen Spannungsabfall verursacht. Einen Komperator pro Zelle vergleicht den an dem jeweiligen Widerstand aufgrund des Stroms verursachten Spannungsabfall mit der Spannung der Batteriezelle und ändert sein Ausgangssignal, sobald der Spannungsabfall über dem Widerstand die Batteriezellspannung überschreitet. Da der Strom sägezahnförmig oder dreiecksförmig verläuft, ist die Zeitdauer bis zum Umschalten des Komperators ein Maß für die Spannung der Batteriezelle. Weil der Strom an allen Zellen parallel vorbeigeführt wird, wird die Spannung aller Zellen gleichzeitig überwacht.

### Zeichnung

Nachfolgend wird ein Ausführungsbeispiel der Erfindung unter Bezugnahme auf die begleitende Zeichnung im Detail beschrieben. In der Zeichnung zeigen:
- Figur 1: ein Prinzipschaltbild des Aufbaues einer bevorzugten Ausführungsform einer erfindungsgemäßen Auswerteschaltung, exemplarisch für sechs Zellen,
- Figur 2: eine erfindungsgemäß bevorzugt eingesetzte Stromspiegelschaltung für die Zellspannungserfassung, und
- Figur 3: ein Prinzipschaltbild einer Zellspannungserfassung nach dem Stand der Technik.

### Bevorzugte Ausführungsform der Erfindung

Nachfolgend wird unter Bezugnahme auf die Figuren eine bevorzugte Ausführungsform der Erfindung im Detail beschrieben.

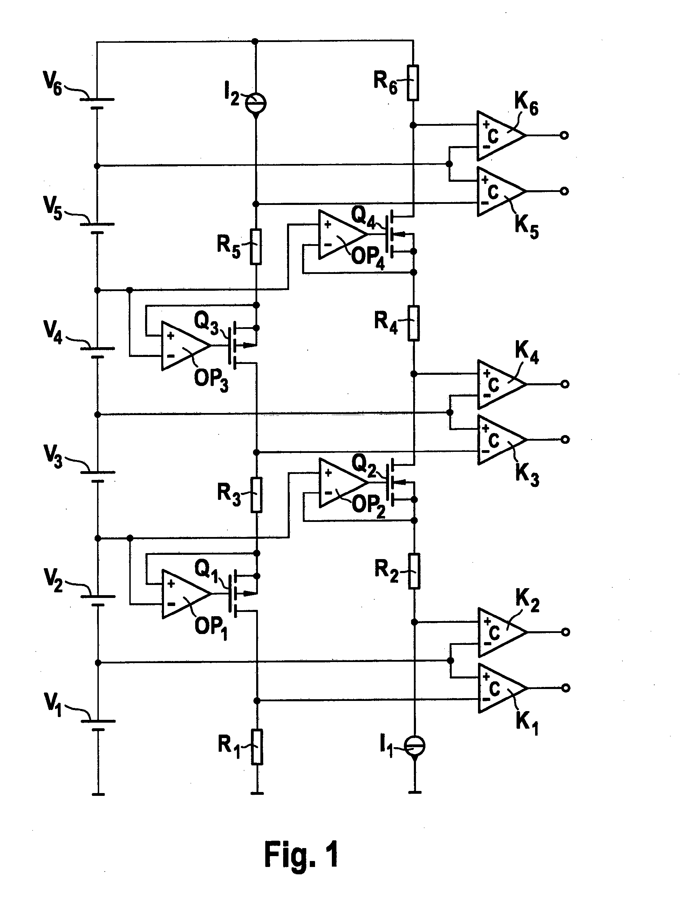

Die Figur 1 zeigt in Reihe geschaltete Batteriezellen V₁ bis V₆, wobei der Minuspol der Batteriezellen V₁ auf Masse liegt und am Pluspol der Batteriezelle V₆ die Gesamtspannung des Batteriesystems anliegt. Eine Stromquelle I₁ erzeugt einen sägezahnförmigen Strom, der aus der Zelle V₆ über eine Reihenschaltung eines Widerstands R₆, eines Transistors Q₄, eines Widerstands R₄, eines Transistors Q₂ und eines Widerstands R₂ entnommen wird. Die Source-Anschlüsse der Transistoren Q₂ und Q₄ werden über Operationsverstärker OP₂ und OP₄, deren positiver Eingang jeweils am positiven Anschluss der jeweiligen Batteriezelle anliegt und deren negativer Eingang jeweils am Masse abgewandten Anschluss des jeweiligen der jeweiligen Batteriezelle zugeordneten Widerstand anliegt und deren Ausgang jeweils mit dem Gate-Anschluss des jeweiligen Transistors verbunden ist, dynamisch auf dem Potential der Anschlüsse der Batteriezellen V₂ und V₄ gehalten. Erhöht sich der Strom der Stromquelle I₁, so steigt der Spannungsabfall über die Widerstände R₂, R₄ und R₆, d.h., die Potentiale an den Masse zugewandten Anschlüssen dieser Widerstände sinken. Diese Potentiale werden jetzt jeweils mit den an den Masse zugewandten Anschlüssen der Batteriezellen V₂, V₄, V₆ über Komparatoren K₂, K4, K₆ verglichen. Der Zeitpunkt des Umschaltens eines Komparators stellt somit ein Maß für die Zellspannung dar.

Aufgrund des gewählten Schaltungskonzeptes ist es notwendig, dass der Spannungsabfall über den jeweiligen Widerständen größer sein kann als die Spannung der gemessenen Batteriezellen. Daher wird in dem gezeigten Ausführungsbeispiel innerhalb eines Strompfads nur jede zweite Zelle - in besagten Schaltplan jede geradzahlige Zelle - gemessen. Um auch die anderen Zellen zu messen, wird zumindest ein zweiter Strompfad benötigt. Dieser ist in Figur 1 durch die Stromquelle I₂ gezeigt, die einen sägezahnförmigen Strom erzeugt, der aus der Zelle V₆ über eine Reihenschaltung eines Widerstands R₅, eines Transistors Q₃, eines Widerstands R₃, eines Transistors Q₁ und eines Widerstands R₁ entnommen wird. Die Source-Anschlüsse der Transistoren Q₃, Q₁ werden über Operationsverstärker OP₃, OP₁, deren negativer Eingang jeweils am negativen Anschluss der jeweiligen Batteriezelle anliegt und deren positiver Eingang jeweils am Masse zugewandten Anschluss des jeweiligen der jeweiligen Batteriezelle zugeordneten Widerstand anliegt und deren Ausgang jeweils mit dem Gate-Anschluss des jeweiligen Transistors verbunden ist, jeweils dynamisch auf dem Potential der Anschlüsse der Zellen V₃ und V₅ gehalten. Erhöht sich der Strom der Stromquelle I₂, so steigt der Spannungsabfall über die Widerstände R₅, R₃ und R₁, d.h., die Potentiale an den Masse abgewandten Anschlüssen dieser Widerstände steigen. Diese Potentiale werden jetzt jeweils mit den an den Masse abgewandten Anschlüssen der Batteriezellen V₅, V₃, V₁ über Komparatoren K₅, K₃, K₁ verglichen. Der Zeitpunkt des Umschaltens eines Komparators stellt somit ein Maß für die Zellspannung dar.

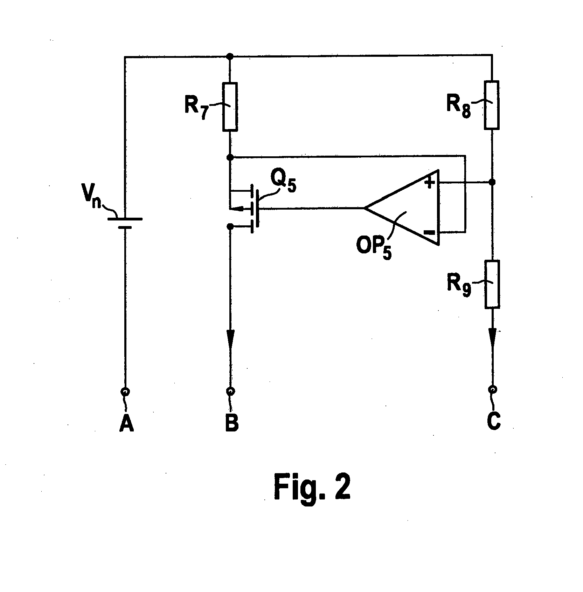

In einer besonders vorteilhaften Ausgestaltung der Erfindung wird der Strom des ersten Pfades an der obersten Zelle gespiegelt und dann wieder bis zur untersten Zelle geführt. Dies erfolgt vorzugsweise mittels der in Figur 2 gezeigten Stromspiegelschaltung. Diese ist hier in allgemeiner Ausführung gezeigt, d.h., mit der Batteriezelle Vₙ, an der die Ausgangsspannung des Batteriesystems anliegt, für die in Figur 1 gezeigte Ausführungsform wäre dies die Batteriezelle V₆. Demzufolge wird der Anschluss A der in Figur 2 gezeigten Stromspiegelschaltung an die nächste Batteriezelle der in Reihe geschalteten Batteriezellen des Batteriesystems angeschlossen, also die Batteriezelle Vn-1, im Ausführungsbeispiel der Figur 1 die Batteriezelle V₅. Der Anschluss B führt zur Stufe n-1 und der Anschluss C führt zur Stufe n-2. Die Stromspiegelschaltung besteht aus einem Transistor Q₅, dessen Source-Anschluss über einen Widerstand R₇ mit der Ausgangsspannung der Batteriezelle Vₙ verbunden ist und dessen Drain-Anschluss mit dem Anschluss B verbunden ist. Der Gate-Anschluss des Transistors Q₅ ist an den Ausgang eines Operationsverstärkers OP₅ angeschlossen, dessen positiver Eingang an den Knoten einer Reihenschaltung von Widerständen R₈, R₉ angeschlossen ist, die zwischen die Ausgangsspannung der Batteriezelle Vₙ und den Anschluss C geschaltet ist, und dessen negativer Eingang mit dem Knoten zwischen dem Widerstand R₇ und dem Source-Anschluss des Transistors Q₅ verbunden ist.

In dem in Figur 1 gezeigten Ausführungsbeispiel werden die Signale der Komperatoren K₁ bis K₆ über Isolatoren einem digitalen Auswerte-IC, beispielsweise einem Mikrocontroller, zugeführt. Bei einer hohen Anzahl von Batteriezellen kann ein Multiplexer zur Auswahl der Zellleitungen verwendet werden.

Neben der vorstehenden schriftlichen Offenbarung der Erfindung wird hiermit explizit auf deren zeichnerische Darstellung in den Fig. 1 bis 3 Bezug genommen.

## Patentansprüche

1. Verfahren zur Erfassung der Spannung von vorzugsweise in Reihe geschalteten Batteriezellen (V₂, V₄, V₆; V₁, V₃, V₅) eines Batteriesystems, gekennzeichnet durch die Schritte
- Anlegen eines abschnittsweise kontinuierlich verlaufenden Stroms (I₁; I₂) an eine Reihenschaltung von Widerständen (R₂, R₄, R₆; R₁, R₃, R₅), deren Anzahl zu der Anzahl der Batteriezellen (V₂, V₄, V₆; V₁, V₃, V₅) korrespondiert, deren Spannung erfasst wird, wobei jeder dieser Batteriezellen (V₂, V₄, V₆; V₁, V₃, V₅) einer der Widerstände (R₂, R₄, R₆; R₁, R₃, R₅) zugeordnet ist,
- Vergleichen der an einem jeweiligen einer Batteriezelle zugeordneten Widerstand (R₂, R₄, R₆; R₁, R₃, R₅) abfallenden Spannung mit der Spannung der Batteriezelle(V₂, V₄, V₆; V₁, V₃, V₅), der der jeweilige Widerstand (R₂, R₄, R₆; R₁, R₃, R₅) zugeordnet ist, und
- Ableiten der Spannung der jeweiligen Batteriezelle (V₂, V₄, V₆; V₁, V₃, V₅) anhand eines Zeitpunkts, an dem eine über den dieser zugeordneten Widerstand (R₂, R₄, R₆; R₁, R₃, R₅) abfallende Spannung der Spannung der jeweiligen Batteriezelle (V₂, V₄, V₆; V₁, V₃, V₅) entspricht, diese übersteigt oder unter diese sinkt, und des Verlaufs des abschnittsweise kontinuierlich verlaufenden Stroms (I₁; I₂).

2. Verfahren nach Anspruch 1, **dadurch gekennzeichnet, dass**
- der abschnittsweise kontinuierlich verlaufende Strom (I₁; I₂) sägezahnförmig oder dreiecksförmig verläuft und/oder kontinuierlich steigt oder fällt.

3. Verfahren nach Anspruch 1 oder 2, **dadurch gekennzeichnet, dass**
- ein Bezugspotential eines einer Batteriezelle (V₂, V₄, V₆; V₁, V₃, V₅) zugeordneten Widerstands (R₂, R₄, R₆; R₁, R₃, R₅) auf ein Bezugspotential der Batteriezelle (V₂, V₄, V₆; V₁, V₃, V₅) gebracht wird.

4. Verfahren nach einem der vorstehenden Ansprüche, **dadurch gekennzeichnet, dass**
- die Spannung einer ersten Hälfte der Batteriezellen (V₂, V₄, V₆) des Batteriesystems mit Hilfe einer ersten Reihenschaltung von Widerständen (R₂, R₄, R₆) und eines an diese angelegten ersten abschnittsweise kontinuierlich verlaufenden Stroms (I₁) erfasst wird, der aus mehr als der Hälfte der Batteriezellen (V₁, V₂, V₃, V₄, V₅, V₆) des Batteriesystems gewonnen wird, und dass
- die Spannung einer zweiten Hälfte der Batteriezellen (V₁, V₃, V₅) des Batteriesystems mit Hilfe einer zweiten Reihenschaltung von Widerständen (R₁, R₃, R₅) und eines an diese angelegten zweiten abschnittsweise kontinuierlich verlaufenden Stroms (I₂) erfasst wird, der aus mehr als der Hälfte der Batteriezellen (V₁, V₂, V₃, V₄, V₅, V₆) des Batteriesystems gewonnen wird.

5. Verfahren nach Anspruch 4, **dadurch gekennzeichnet, dass**
- der zweite Strom (II₂) erzeugt wird, indem der erste Strom (I₁) gespiegelt wird.

6. Auswerteschaltung zur Erfassung der Spannung von vorzugsweise in Reihe geschalteten Batteriezellen (V₂, V₄, V₆; V₁, V₃, V₅) eines Batteriesystems, gekennzeichnet durch
- eine Reihenschaltung von Widerständen (R₂, R₄, R₆; R₁, R₃, R₅), deren Anzahl zu der Anzahl der Batteriezellen (V₂, V₄, V₆; V₁, V₃, V₅) korrespondiert, deren Spannung erfasst werden soll, wobei jeder dieser Batteriezellen (V₂, V₄, V₆; V₁, V₃, V₅) einer der Widerstände (R₂, R₄, R₁, R₃, R₅) zugeordnet ist,
- eine Stromquelle (I₁; I₂) zur Erzeugung eines abschnittsweise kontinuierlich verlaufenden Stroms (I₁; I₂), der an die Reihenschaltung von Widerständen (R₂, R₄, R₆; R₁, R₃, R₅) angelegt wird,
- eine Anzahl von Komparatoren (K₂, K₄, K₆, K₁, K₃, K₅), die der Anzahl von Widerständen (R₂, R₄, R₆; R₁, R₃, R₅) entspricht, zum Vergleichen einer an einem jeweiligen einer Batteriezelle (V₂, V₄, V₆; V₁, V₃, V₅) zugeordneten Widerstand (R₂, R₄, R₆; R₁, R₃, R₅) abfallenden Spannung mit der Spannung der Batteriezelle (V₂, V₄, V₆; V₁, V₃, V₅), der der jeweilige Widerstand (R₂, R₄, R₆; R₁, R₃, R₅) zugeordnet ist, und zum Ausgeben eines jeweiligen Ausgangssignals, wenn die an einem jeweiligen einer Batteriezelle (V₂, V₄, V₆; V₁, V₃, V₅) zugeordneten Widerstand (R₂, R₄, R₆; R₁, R₃, R₅) abfallende Spannung der Spannung der Batteriezelle (V₂, V₄, V₆; V₁, V₃, V₅) entspricht, diese übersteigt oder unter diese sinkt,
- eine Auswerteschaltung zum Ableiten der Spannung der jeweiligen Batteriezelle (V₂, V₄, V₆; V₁, V₃, V₅) anhand eines Zeitpunkts, an dem das jeweilige Ausgangssignal ausgegeben wird und des Verlaufs des abschnittsweise kontinuierlich verlaufenden Stroms (I₁; I₂).

7. Auswerteschaltung nach Anspruch 6, **dadurch gekennzeichnet, dass**
- die Stromquelle einen abschnittsweise kontinuierlich verlaufenden Strom (I₁; I₂) erzeugt, der sägezahnförmig oder dreiecksförmig verläuft und/oder kontinuierlich steigt oder fällt.

8. Auswerteschaltung nach Anspruch 6 oder 7, gekennzeichnet durch
- eine Potentialverschiebeschaltung (OP₁, OP₂, OP₃, OP₄), die ein Bezugspotential eines einer Batteriezelle (V₃, V₂, V₅, V₄) zugeordneten Widerstands (R₃, R₂, R₅, R₄) auf ein Bezugspotential der Batteriezelle (V₃, V₂, V₅, V₄) bringt.

9. Auswerteschaltung nach einem der vorstehenden Ansprüche 6 bis 8, gekennzeichnet durch
- eine erste Reihenschaltung von Widerständen (R₂, R₄, R₆) und eine erste Stromquelle (I₁), die einen ersten abschnittsweise kontinuierlich verlaufenden Strom (I₁) an die erste Reihenschaltung von Widerständen (R₂, R₄, R₆) anlegt, der aus mehr als der Hälfte der Batteriezellen (V₁, V₂, V₃, V₄, V₅, V₆) des Batteriesystems gewonnen wird, um die Spannung einer ersten Hälfte der Batteriezellen (V₂, V₄, V₆) des Batteriesystems zu erfassen, und
- eine zweite Reihenschaltung von Widerständen (R₁, R₃, R₅) und eine zweite Stromquelle (I₂), die einen zweiten abschnittsweise kontinuierlich verlaufenden Strom (I₂) an die zweite Reihenschaltung von Widerständen (R₁, R₃, R₅) anlegt, der aus mehr als der Hälfte der Batteriezellen (V₁, V₂, V₃, V₄, V₅, V₆) des Batteriesystems gewonnen wird, um die Spannung einer zweiten Hälfte der Batteriezellen (V₁, V₃, V₅) des Batteriesystems zu erfassen.

10. Auswerteschaltung nach Anspruch 9, gekennzeichnet durch
- eine Stromspiegelschaltung (Q₅, OP₅, R₇, R_{8,} R₉) zur Erzeugung des zweiten Stroms (I₂) durch Spiegeln des ersten Stroms (I₁).

## Claims

1. Method for detecting the voltage of preferably series-connected battery cells (V₂, V₄, V₆; V₁, V₃, V₅) of a battery system,
**characterized by** the steps of:
- applying a current (I₁; I₂) which runs continuously in sections to a series connection of resistors (R₂, R₄, R₆; R₁, R₃, R₅) the number of which corresponds to the number of battery cells (V₂, V₄, V₆; V₁, V₃, V₅) the voltage of which is detected, wherein each of said battery cells (V₂, V₄, V₆; V₁, V₃, V₅) is assigned to one of the resistors (R₂, R₄, R₆; R₁, R₃, R₅),
- comparing the voltage dropping across a respective resistor (R₂, R₄, R₆; R₁, R₃, R₅) assigned to a battery cell with the voltage of the battery cell (V₂, V₄, V₆; V₁, V₃, V₅) to which the respective resistor (R₂, R₄, R₆; R₁, R₃, R₅) is assigned, and
- deriving the voltage of the respective battery cell (V₂, V₄, V₆; V₁, V₃, V₅) on the basis of an instant at which a voltage dropping across the resistor (R₂, R₄, R₆; R₁, R₃, R₅) assigned to said battery cell corresponds to the voltage of the respective battery cell (V₂, V₄, V₆; V₁, V₃, V₅), exceeds same or falls below same, and of the profile of the current (I₁; I₂) which runs continuously in sections.

2. Method according to Claim 1, **characterized in that**
- the current (I₁; I₂) which runs continuously in sections has a sawtooth or triangular profile and/or continuously rises or falls.

3. Method according to Claim 1 or 2, **characterized in that**
- a reference potential of a resistor (R₂, R₄, R₆; R₁, R₃, R₅) assigned to a battery cell (V₂, V₄, V₆; V₁, V₃, V₅) is brought to a reference potential of the battery cell (V₂, V₄, V₆; V₁, V₃, V₅).

4. Method according to any of the preceding claims, **characterized in that**
- the voltage of a first half of the battery cells (V₂, V₄, V₆) of the battery system is detected using a first series connection of resistors (R₂, R₄, R₆) and a first current (I₁) which runs continuously in sections, is applied to said resistors and is obtained from more than half of the battery cells (V₁, V₂, V₃, V₄, V₅, V₆) of the battery system, and in that
- the voltage of a second half of the battery cells (V₁, V₃, V₅) of the battery system is detected using a second series connection of resistors (R₁, R₃, R₅) and a second current (I₂) which runs continuously in sections, is applied to said resistors and is obtained from more than half of the battery cells (V₁, V₂, V₃, V₄, V₅, V₆) of the battery system.

5. Method according to Claim 4, **characterized in that**
- the second current (I₂) is generated by the first current (I₁) being mirrored.

6. Evaluation circuit for detecting the voltage of preferably series-connected battery cells (V₂, V₄, V₆; V₁, V₃, V₅) of a battery system,
**characterized by**:
- a series connection of resistors (R₂, R₄, R₆; R₁, R₃, R₅) the number of which corresponds to the number of battery cells (V₂, V₄, V₆; V₁, V₃, V₅) the voltage of which is to be detected, wherein each of said battery cells (V₂, V₄, V₆; V₁, V₃, V₅) is assigned to one of the resistors (R₂, R₄, R₆; R₁, R₃, R₅),
- a current source (I₁; I₂) for generating a current (I₁; I₂) which runs continuously in sections and is applied to the series connection of resistors (R₂, R₄, R₆; R₁, R₃, R₅),
- a number of comparators (K₂, K₄, K₆, K₁, K₃, K₅) which corresponds to the number of resistors (R₂, R₄, R₆; R₁, R₃, R₅) for comparing a voltage dropping across a respective resistor (R₂, R₄, R₆; R₁, R₃, R₅) assigned to a battery cell (V₂, V₄, V₆; V₁, V₃, V₅) with the voltage of the battery cell (V₂, V₄, V₆; V₁, V₃, V₅) to which the respective resistor (R₂, R₄, R₆; R₁, R₃, R₅) is assigned and for outputting a respective output signal if the voltage dropping across a respective resistor (R₂, R₄, R₆; R₁, R₃, R₅) assigned to a battery cell (V₂, V₄, V₆; V₁, V₃, V₅) corresponds to the voltage of the battery cell (V₂, V₄, V₆; V₁, V₃, V₅), exceeds same or falls below same, and
- an evaluation circuit for deriving the voltage of the respective battery cell (V₂, V₄, V₆; V₁, V₃, V₅) on the basis of an instant at which the respective output signal is output, and of the profile of the current (I₁; I₂) which runs continuously in sections.

7. Evaluation circuit according to Claim 6, **characterized in that**
- the current source generates a current (I₁; I₂) which runs continuously in sections, has a sawtooth or triangular profile and/or continuously rises or falls.

8. Evaluation circuit according to Claim 6 or 7, **characterized by**
- a potential shift circuit (OP₁, OP₂, OP₃, OP₄), which brings a reference potential of a resistor (R₃, R₂, R₅, R₄) assigned to a battery cell (V₃, V₂, V₅, V₄) to a reference potential of the battery cell (V₃, V₂, V₅, V₄).

9. Evaluation circuit according to any of the preceding Claims 6 to 8,
**characterized by**
- a first series connection of resistors (R₂, R₄, R₆) and a first current source (I₁) which applies a first current (I₁) which runs continuously in sections to the first series connection of resistors (R₂, R₄, R₆) and which is obtained from more than half of the battery cells (V₁, V₂, V₃, V₄, V₅, V₆) of the battery system in order to detect the voltage of a first half of the battery cells (V₂, V₄, V₆) of the battery system, and
- a second series connection of resistors (R₁, R₃, R₅) and a second current source (I₂) which applies a second current (I₂) which runs continuously in sections to the second series connection of resistors (R₁, R₃, R₅) and which is obtained from more than half of the battery cells (V₁, V₂, V₃, V₄, V₅, V₆) of the battery system in order to detect the voltage of a second half of the battery cells (V₁, V₃, V₅) of the battery system.

10. Evaluation circuit according to Claim 9, **characterized by**
- a current mirroring circuit (Q₅, OP₅, R₇, R₈, R₉) for generating the second current (I₂) by mirroring the first current (I₁).

## Revendications

1. Procédé de saisie de la tension de cellules de batterie (V₂, V₄, V₆ ; V₁, V₃, V₅), raccordées de préférence en série, d'un système de batterie, **caractérisé par** les étapes qui consistent à :
- appliquer un courant (I₁ ; I₂) qui s'écoule par parties continues sur un circuit série de résistances (R₂, R₄, R₆ ; R₁, R₃, R₅) dont le nombre correspond au nombre des cellules de batterie (V₂, V₄, V₆ ; V₁, V₃, V₅) et dont la tension est saisie, chacune des résistances (R₂, R₄, R₆ ; R₁, R₃, R₅) étant associée à l'une de ces cellules de batterie (V₂, V₄, V₆ ; V₁, V₃, V₅),
- comparer la chute de tension aux bornes d'une résistance (R₂, R₄, R₆ ; R₁, R₃, R₅) associée à chaque cellule de batterie à la tension de la cellule de batterie (V₂, V₄, V₆ ; V₁, V₃, V₅) associée à la résistance (R₂, R₄, R₆ ; R₁, R₃, R₅) respective et
- déduire la tension de chaque cellule de batterie (V₂, V₄, V₆ ; V₁, V₃, V₅) à l'aide de l'instant auquel une chute de tension aux bornes de la résistance (R₂, R₄, R₆ ; R₁, R₃, R₅) qui lui est associée correspond à la tension de la cellule de batterie (V₂, V₄, V₆ ; V₁, V₃, V₅) respective, la dépasse ou descend en dessous d'elle, et de l'évolution du courant (I₁ ; I₂) qui s'écoule par parties continues.

2. Procédé selon la revendication 1, **caractérisé en ce que** le courant (I₁ ; I₂) qui s'écoule par parties continues s'étend en dents de scie ou en triangles et/ou augmente ou diminue de manière continue.

3. Procédé selon les revendications 1 ou 2, **caractérisé en ce qu'**un potentiel de référence de l'une des résistances (R₂, R₄, R₆ ; R₁, R₃, R₅) associée à une cellule de batterie (V₂, V₄, V₆ ; V₁, V₃, V₅) est amené au potentiel de référence de la cellule de batterie (V₂, V₄, V₆ ; V₁, V₃, V₅).

4. Procédé selon l'une des revendications précédentes, **caractérisé en ce que** la tension de la première moitié des cellules de batterie (V₂, V₄, V₆) du système de batterie est saisie à l'aide d'un premier circuit série de résistances (R₂, R₄, R₆) et d'un premier courant (I₁) s'écoulant par parties continues appliqué sur ces dernières, obtenu à partir de plus de la moitié des cellules de batterie (V₁, V₂, V₃, V₄, V₅, V₆) du système de batterie, et **en ce que** la tension d'une deuxième moitié de cellules de batterie (V₁, V₃, V₅) du système de batterie est saisie à l'aide d'un deuxième circuit série de résistances (R₁, R₃, R₅) et d'un deuxième courant (I₂) s'écoulant par parties continues appliqué sur ces dernières, obtenu à partir de plus de la moitié des cellules de batterie (V₁, V₂, V₃, V₄, V₅, V₆) du système de batterie.

5. Procédé selon la revendication 4, **caractérisé en ce que** le deuxième courant (I₂) est formé en miroir du premier courant (I₁).

6. Circuit d'évaluation destiné à saisir la tension de cellules de batterie (V₂, V₄, V₆ ; V₁, V₃, V₅), de préférence raccordées en série, d'un système de batterie, **caractérisé par** :
- un circuit série de résistances (R₂, R₄, R₆ ; R₁, R₃, R₅) dont le nombre correspond au nombre des cellules des batteries (V₂, V₄, V₆ ; V₁, V₃, V₅) dont la tension doit être saisie, chacune des résistances (R₂, R₄, R₆ ; R₁, R₃, R₅) étant associée à l'une de ces cellules de batterie (V₂, V₄, V₆ ; V₁, V₃, V₅),
- une source de courant (I₁ ; I₂) qui forme un courant (I₁ ; I₂) qui s'étend par parties continues, appliqué sur le circuit série de résistances (R₂, R₄, R₆ ; R₁, R₃, R₅),
- plusieurs comparateurs (K₂, K₄, K₆, K₁, K₃, K₅) dont le nombre correspond au nombre de résistances (R₂, R₄, R₆ ; R₁, R₃, R₅), qui comparent la chute de tension aux bornes de la résistance (R₂, R₄, R₆ ; R₁, R₃, R₅) associées à chaque cellule de batterie (V₂, V₄, V₆ ; V₁, V₃, V₅) à la tension de la cellule de batterie (V₂, V₄, V₆ ; V₁, V₃, V₅) associée à chaque résistance (R₂, R₄, R₆ ; R₁, R₃, R₅) et qui délivrent un signal de sortie correspondant si la chute de tension aux bornes de chaque résistance (R₂, R₄, R₆ ; R₁, R₃, R₅) associée à une cellule de batterie (V₂, V₄, V₆ ; V₁, V₃, V₅) correspond à la tension de la cellule de batterie (V₂, V₄, V₆ ; V₁, V₃, V₅), la dépasse ou descend en dessous d'elle et
- un circuit d'évaluation qui déduit la tension de chaque cellule de batterie (V₂, V₄, V₆ ; V₁, V₃, V₅) à l'aide de l'instant auquel le signal de sortie est délivré et de l'évolution du courant (I₁ ; I₂) qui s'écoule par parties continues.

7. Circuit d'évaluation selon la revendication 6, **caractérisé en ce que** la source de courant forme un courant (I₁ ; I₂) qui s'écoule par parties continues, en dents de scie ou en triangles et/ou qui augmente ou diminue de manière continue.

8. Circuit d'évaluation selon les revendications 6 ou 7, **caractérisé par** un circuit (OP₁, OP₂, OP₃, OP₄) de décalage de potentiel qui amène le potentiel de référence d'une résistance (R₃, R₂, R₅, R₄) associée à une cellule de batterie (V₃, V₂, V₅, V₄) au potentiel de référence de la cellule de batterie (V₃, V₂, V₅, V₄).

9. Circuit d'évaluation selon l'une des revendications 6 à 8 qui précèdent, **caractérisé par**
- un premier circuit série de résistances (R₂, R₄, R₆) et une première source de courant (I₁) qui applique un premier courant (I₁) qui s'écoule par parties continues sur le premier circuit série de résistances (R₂, R₄, R₆) et qui est obtenu à partir de plus de la moitié des cellules de batterie (V₁, V₂, V₃, V₄, V₅, V₆) du système de batterie, pour saisir la tension d'une première moitié des cellules de batterie (V₂, V₄, V₆) du système de batterie et
- un deuxième circuit série de résistances (R₁, R₃, R₅) et une deuxième source de courant (I₂) qui applique un deuxième courant (I₂) qui s'écoule par parties continues sur le deuxième circuit série de résistances (R₁, R₃, R₅) et qui est obtenu à partir de plus de la moitié des cellules de batteries (V₁, V₂, V₃, V₄, V₅, V₆) du système de batterie, pour saisir la tension d'une deuxième moitié des cellules de batterie (V₁, V₃, V₅) du système de batterie.

10. Circuit d'évaluation selon la revendication 9, **caractérisé par** un circuit (Q₅, OP₅, R₇, R₈, R₉) de miroir de courant qui forme le deuxième courant (I₂) en miroir du premier courant (I₁).
